Europäisches Patentamt

European Patent Office

Office européen des brevets

(19)

(11) **EP 1 178 134 A1**

(12) # DEMANDE DE BREVET EUROPEEN

(43) Date de publication:
**06.02.2002 Bulletin 2002/06**

(21) Numéro de dépôt: **00202764.7**

(22) Date de dépôt: **04.08.2000**

(51) Int Cl.[7]: **C23F 4/00**, C23G 3/02,
C21D 1/38, C21D 9/56,
C23C 14/02, H01J 37/32,
H01J 37/34

(84) Etats contractants désignés:
**AT BE CH CY DE DK ES FI FR GB GR IE IT LI LU MC NL PT SE**
Etats d'extension désignés:
**AL LT LV MK RO SI**

(71) Demandeur: **Cold Plasma Applications C.P.A. 1300 Limal (BE)**

(72) Inventeurs:
• **Brande vanden, Pierre**
**1040 Belgique (BE)**
• **Weymeersch, Alain**
**1300 Wavre (BE)**

(74) Mandataire: **Callewaert, Jean**
**Bureau Callewaert b.v.b.a. Brusselsesteenweg 108**
**3090 Overijse (BE)**

(54) **Procédé et dispositif pour traiter des substrats métalliques au défilé par plasma**

(57) L'invention est relative à un procédé et un dispositif de traitement, notamment de nettoyage et/ou de chauffage, d'un substrat métallique (1) défilant d'une manière sensiblement continue dans une chambre à vide (3) présentant une zone de traitement dans laquelle une décharge électrique (10), c.à.d. un plasma, et un champ magnétique sont produits dans un gaz maintenu à une pression inférieure à la pression atmosphérique entre au moins le substrat (1), formant une électrode, et au moins une contre-électrode (9) afin que le substrat (1) puisse être bombardé par des ions produits dans la décharge électrique (10). Ce procédé est caractérisé en ce qu'un champ d'induction magnétique de confinement est réalisé tout autour du substrat (1) dans la zone de traitement de sorte que la décharge électrique (10) est également confinée tout autour du substrat (1) dans cette zone de traitement par le confinement d'électrons libérés dans la décharge électrique (10).

*Fig. 1*

EP 1 178 134 A1

**Description**

La présente invention est relative à un procédé de traitement, notamment de nettoyage et/ou de chauffage par une décharge électrique, c.à.d. par plasma, de substrats métalliques tels que des produits se présentant sous forme de fils, de tubes, de poutrelles, de bandes ou et de tôles. Dans ce procédé le substrat à traiter est déplacé suivant un sens déterminé dans une enceinte présentant une zone de traitement dans laquelle une décharge électrique est créée entre une contre-électrode et le substrat, à proximité de la surface de ce dernier.

Ce procédé permet d'éliminer une couche de contamination du substrat, comme par exemple de l'oxyde métallique superficiel et du carbone superficiel, de manière à favoriser l'adhésion d'un revêtement appliqué ultérieurement sur ce produit par une technique de dépôt sous vide.

Ce procédé permet aussi de chauffer efficacement le substrat et peut, par conséquent, servir au recuit de produits métalliques. Il est applicable aussi bien aux substrats en acier doux, inox, aluminium, cuivre et autres métaux.

Les procédés connus pour le nettoyage ou le chauffage d'un produit métallique par plasma présentent plusieurs désavantages. Selon l'état de la technique il n'est par exemple pas possible de traiter, en une seule opération, toutes les surfaces extérieures du produit.

En particulier, pour traiter une bande métallique plate avec une face supérieure et une face inférieure, on traite successivement les deux faces en réalisant un plasma successivement à proximité des deux faces. Ceci a comme inconvénient important, une recontamination possible de la face qui a été traitée dans la première étape lors du traitement de la deuxième face dans la seconde étape.

Pour pouvoir traiter la bande métallique efficacement, on réalise généralement à la surface de cette dernière une décharge magnétron en disposant à l'arrière de la surface à traiter des réseaux d'aimants.

Un autre inconvénient majeur de la technique connue est l'adaptation de la taille des réseaux d'aimants à la largeur de bande et l'impossibilité de traiter des fils et tubes par cette technique.

Un des buts essentiels de la présente invention est de proposer un procédé qui permette de remédier à ce type d'inconvénients.

A cet effet, dans le procédé, suivant l'invention, un champ d'induction magnétique de confinement est réalisé tout autour du substrat dans la zone de traitement de sorte que la décharge électrique est confinée tout autour du substrat par le confinement des électrons libérés dans la décharge, de manière à permettre la formation d'un plasma de haute densité tout autour du substrat.

Avantageusement, on réalise dans la zone de traitement précitée un champ d'induction magnétique sensiblement parallèle à l'axe de défilement du substrat dans cette zone de traitement d'une manière telle à permettre ainsi la formation d'une décharge magnétron autour du substrat par une circulation d'électrons de la décharge selon des trajectoires s'étendant autour du substrat.

Suivant une forme de réalisation particulièrement avantageuse du procédé, suivant l'invention, au moins un miroir magnétique est réalisé au moins partiellement autour du substrat, de sorte que la décharge électrique est confinée principalement par ce miroir magnétique autour du substrat dans la zone de traitement.

D'une manière intéressante, un champ d'induction magnétique est créé qui s'étend sensiblement transversalement à la direction de déplacement du substrat, et qui présente une valeur minimale à proximité de la surface du substrat où la décharge électrique est confinée. En particulier, l'intensité de ce champ magnétique augmente au moins d'un facteur deux depuis le substrat jusqu'au miroir magnétique précité. Les électrons s'éloignant du substrat, sont, par conséquent, réfléchis et renvoyés vers le substrat ayant pour effet le confinement de la décharge électrique autour du substrat.

Suivant une autre forme de réalisation avantageuse, on réalise au moins deux miroirs magnétiques qui sont traversés par le substrat et qui définissent l'entrée et la sortie de la zone de traitement. Ces miroirs magnétiques permettent de confiner la décharge électrique dans une direction sensiblement parallèle à l'axe de défilement du substrat dans la zone de traitement.

Un champ d'induction magnétique est formé par ces miroirs magnétiques qui est sensiblement parallèle à la direction de défilement du substrat. L'intensité de ce champ d'induction décroît en s'éloignant de chaque miroir vers le centre de la zone de traitement.

L'invention est aussi relative à un dispositif pour le traitement d'un substrat métallique, notamment pour le nettoyage et/ou le chauffage d'un substrat métallique, comprenant une chambre à vide pourvue d'une ouverture d'entrée et d'une ouverture de sortie pour le substrat. Dans cette chambre à vide, qui présente une zone de traitement dans laquelle est créée la décharge électrique, peut défiler le substrat d'une manière sensiblement continue. Le dispositif présente des moyens magnétiques de confinement d'électrons produits dans la décharge électrique et comprend au moins une contre-électrode disposée en regard du substrat formant une électrode.

Le dispositif, selon l'invention, est caractérisé en ce que les moyens magnétiques de confinement sont disposés d'une manière telle par rapport au substrat pour que les ions produits dans la décharge électrique puissent se maintenir tout autour du substrat et ainsi bombarder la surface de ce dernier. Plus particulièrement, les moyens magnétiques de confinement sont pourvus au moins partiellement autour la zone de traitement.

Avantageusement, au moins un miroir magnétique est disposé autour de la zone de traitement dans laquelle défile le substrat, d'une manière telle à réfléchir et renvoyer vers le substrat les électrons s'éloignant de ce dernier et, par conséquent, à confiner la décharge électrique autour du substrat dans cette zone.

Les moyens magnétiques de confinement comprennent de préférence au moins un solénoïde autour de la zone de traitement, d'axe sensiblement parallèle à la direction de défilement du substrat. La section transversale du solénoïde, perpendiculairement à son axe, peut être de forme généralement quelconque, par exemple circulaire pour un solénoïde cylindrique ou rectangulaire pour un solénoïde parallélépipédique.

Dans une forme de réalisation intéressante de l'invention, le dispositif comprend au moins deux miroirs magnétiques entre l'ouverture d'entrée et l'ouverture de sortie, délimitant la zone de traitement dans la direction de défilement du substrat.

D'autres détails et particularités de l'invention ressortiront de la description donnée ci-après, à titre d'exemple non limitatif, de quelques formes de réalisation particulières de l'invention avec référence aux dessins annexés.

La figure 1 est une vue schématique en coupe transversale parallèle à l'axe de défilement du produit d'une première forme de réalisation du dispositif, selon l'invention.

La figure 2 est un graphique qui représente la valeur de la composante du champ d'induction magnétique au voisinage du substrat suivant la direction de déplacement du substrat dans le dispositif de la figure 1.

La figure 3 est une vue schématique en coupe transversale parallèle à l'axe de défilement du produit d'une deuxième forme de réalisation du dispositif, selon l'invention.

La figure 4 est un graphique qui représente la valeur de la composante du champ d'induction magnétique au voisinage du substrat suivant la direction de déplacement du substrat dans le dispositif de la figure 3.

La figure 5 est une vue schématique en coupe transversale parallèle à l'axe de défilement du produit d'une troisième forme de réalisation du dispositif, selon l'invention.

La figure 6 est un graphique qui représente la valeur de la composante du champ d'induction magnétique au voisinage du substrat suivant la direction de déplacement du substrat dans le dispositif de la figure 5.

La figure 7 est une vue schématique en coupe transversale parallèle à l'axe de défilement du produit d'une quatrième forme de réalisation du dispositif, selon l'invention.

La figure 8 est un graphique qui représente la valeur de la composante du champ d'induction magnétique au voisinage du substrat suivant la direction de déplacement du substrat dans le dispositif de la figure 7.

La figure 9 est une vue schématique en coupe transversale parallèle à l'axe de défilement du produit d'une cinquième forme de réalisation du dispositif, selon l'invention.

La figure 10 est un graphique qui représente la valeur de la composante du champ d'induction magnétique au voisinage du substrat suivant la direction de déplacement du substrat dans le dispositif de la figure 9.

La figure 11 est une vue schématique en coupe transversale parallèle à l'axe de défilement du produit d'une sixième forme de réalisation du dispositif, selon l'invention.

La figure 12 est un graphique qui représente la valeur de la composante du champ d'induction magnétique au voisinage du substrat suivant la direction de déplacement du substrat dans le dispositif de la figure 11.

La figure 13 est une vue schématique en coupe transversale parallèle à l'axe de défilement du produit d'une septième forme de réalisation du dispositif, selon l'invention.

La figure 14 est un graphique qui représente la valeur de la composante du champ d'induction magnétique au voisinage du substrat suivant la direction de déplacement du substrat dans le dispositif de la figure 13.

La figure 15 est un détail en coupe transversale parallèle à l'axe de défilement du produit d'une représentation schématique de la décharge indiquant le comportement des électrons entre deux miroirs magnétiques.

La figure 16 est une vue schématique en coupe transversale perpendiculaire à la direction de déplacement du produit, illustrant la formation d'une décharge magnétron autour du produit.

Dans les différentes figures, les mêmes chiffres de référence concernent des éléments identiques ou analogues.

Le procédé suivant l'invention consiste à créer à proximité de la surface d'un substrat à nettoyer ou à chauffer un plasma dans un mélange gazeux comprenant par exemple un ou plusieurs des éléments suivants : Ar, He, $H_2$, $O_2$ ou $N_2$, ou des composés hydrocarbonés. Le gaz est maintenu à une pression P inférieure à la pression atmosphérique, de manière à générer des radicaux et des ions permettant le nettoyage et l'augmentation de température de ce substrat. La pression P peut par exemple être comprise entre $10^{-2}$ Pa et 1000 Pa.

Ce procédé permet un nettoyage ou un chauffage de substrats avec une cinétique élevée étant donné qu'il est basé sur la création d'un plasma à haute densité n dans le gaz maintenu à basse pression. Cette densité de plasma n correspond généralement à une densité électronique comprise entre $10^{10}$ $cm^{-3}$ et $10^{12}$ $cm^{-3}$. Le plasma étant à haute densité, des puissances élevées peuvent être dissipées à la surface du substrat, principalement sous la forme d'un bombardement d'ions.

En particulier, la décharge électrique est produite sous une différence de potentiel maximale maintenue entre le substrat et une contre-électrode inférieure ou égale à 1000 V pour des densités de puissance moyennes par unité de surface de substrat comprises entre 1 Wcm$^{-2}$ et 200 Wcm$^{-2}$.

La décharge, pour la formation d'un plasma, est obtenue en polarisant le substrat négativement par rapport à une contre-électrode, soit d'une manière continue, soit d'une manière cyclique. Dans le premier cas, il s'agit d'une décharge électrique continue et la contre-électrode est une anode. Dans le second cas, il s'agit d'une décharge alternative durant laquelle le substrat n'est bombardé par des ions que lorsqu'il est polarisé négativement par rapport à la contre-électrode.

La forme du signal de la tension utilisée pour une décharge alternative peut être sinusoïdale, simplement redressée, carrée dans le cas de courants pulsés ou généralement quelconque. La durée de la partie positive du signal en tension n'est pas nécessairement égale à celle de la partie négative sur une période. La fréquence d'excitation est typiquement comprise entre 1 kHz et 1MHz et est de préférence comprise entre 10 kHz et 100 kHz. Avantageusement, le substrat est maintenu à la masse.

De préférence, le temps durant lequel la contre-électrode est polarisée négativement par rapport à la surface du substrat est plus court que le temps durant lequel elle est polarisée positivement.

Le confinement des électrons de la décharge entre deux ou plusieurs miroirs magnétiques successifs traversés par le substrat métallique permet d'augmenter la densité d'un plasma réalisé autour de ce dernier.

Par miroir magnétique, il y a lieu d'entendre, dans le cadre de la présente invention, un champ magnétique d'une valeur relativement élevée par rapport à un champ magnétique voisin pour que des électrons présents dans ce champ voisin et se déplaçant vers le champ magnétique d'une valeur élevée puissent être réfléchis dans la zone au règne le champs de valeur plus basse.

Ces miroirs magnétiques peuvent par exemple être réalisés au moyen de deux solénoïdes entourant le substrat métallique ou encore au moyen d'aimants permanents.

Le procédé, suivant l'invention, est particulièrement intéressant pour traiter des substrats longs ou continus. Le substrat est alors déplacé suivant sa direction longitudinale à travers une enceinte dans laquelle le plasma est créé.

Dans une configuration préférentielle, les miroirs magnétiques sont placés d'une telle manière qu'ils génèrent un champ d'induction sensiblement parallèle à l'axe de déplacement du substrat, le champ croissant en direction de chaque miroir. Le champ d'induction magnétique produit au milieu d'un miroir magnétique est de préférence au moins égal à 5.10$^{-3}$ T ou 50 Gauss.

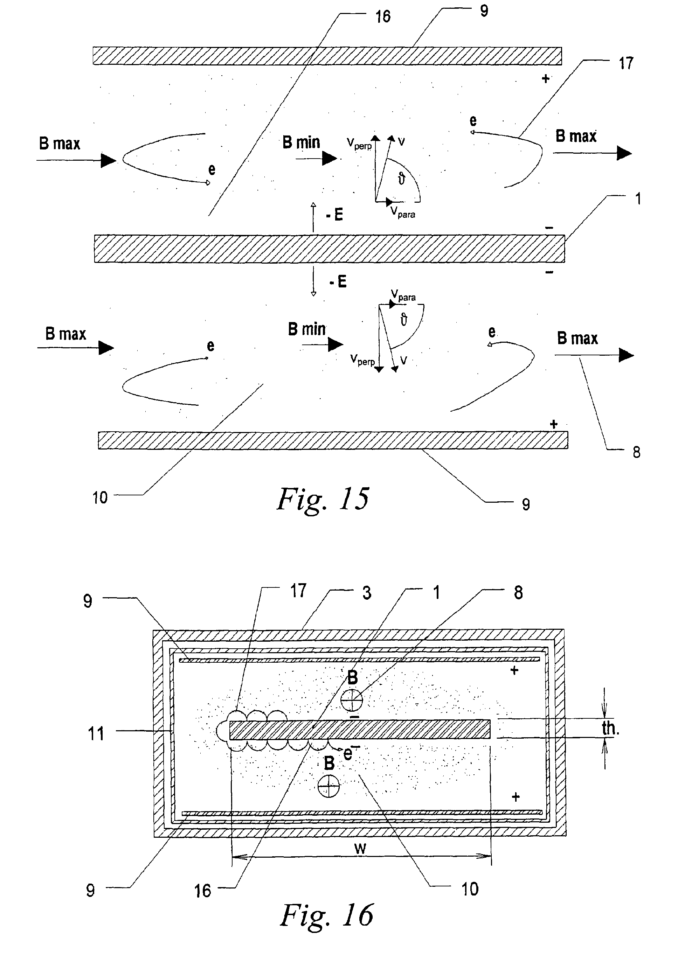

Comme représenté schématiquement dans la figure 15, les électrons secondaires générés lors du bombardement de la surface du substrat 1 par les ions de la décharge et accélérés dans une gaine 16 entourant la surface du substrat, sont réfléchis par les miroirs magnétiques tant qu'ils n'ont pas perdus la plus grande partie de leur énergie cinétique dans les processus d'ionisation.

En effet, au dessus d'une certaine valeur critique de la composante perpendiculaire $v_{perp}$ du vecteur vitesse d'un électron par rapport à la direction du champ d'induction, qui est sensiblement parallèle à la direction de déplacement du substrat 1, l'électron reste confiné entre deux miroirs magnétiques voisins.

Par gaine, on comprend la zone de charge d'espace, dont l'épaisseur ne dépasse généralement pas plus de quelques millimètres, qui s'établit et sépare naturellement toute surface en contact avec un plasma. Lorsque cette surface est celle d'une électrode et que cette électrode est portée à un potentiel négatif par rapport à celui d'une contre-électrode ou anode, la gaine qui y est formée porte le nom gaine cathodique. La plus grande partie de la différence de potentiel appliquée entre cette cathode et la contre-électrode ou anode se retrouve alors au niveau de cette gaine cathodique. Pour cette raison, la gaine cathodique est le siège de l'accélération des ions positifs vers la cathode et le siège de l'accélération des électrons secondaires émis vers le plasma suite à l'impact des ions à la cathode.

Si $B_{min}$ représente le champ d'induction magnétique minimum entre deux miroirs successifs et $B_{max}$ correspond au champ d'induction magnétique parallèle à l'axe central, entre ces deux miroirs, généré au niveau de chaque miroir, on montre que, pour une symétrie axiale avec $B_{min}$ parallèle au sens de déplacement du substrat 1, un électron reste confiné entre ces deux miroirs lorsque le rapport de la composante perpendiculaire $v_{perp}$ de la vitesse de l'électron à son module vitesse totale $v$ est supérieur à une valeur critique égale à $\sin\theta_{cr} = (B_{min}/B_{max})^{1/2}$ avec $\theta$ l'angle entre la direction du champ d'induction et la vitesse totale $v$. Voir par exemple : [J. R. Roth, Industrial Plasma Engineering, Vol. 1, IOP Publishing (1995), ISBN 0 7503 0318 2, pp 75-90]. Se référer à la Fig. 15.

On exprime qu'un électron s'échappe au travers des miroirs lorsque l'angle d'échappement $\theta$ est inférieur à l'angle critique d'échappement $\theta_{cr}$, ce qui se traduit mathématiquement sous la forme :

$$\frac{V_{perp}}{V} = \sin\theta < \sin\theta_{cr} = \sqrt{\frac{B_{min}}{B_{max}}}$$

Le champ électrique **E** de la gaine 16 étant toujours perpendiculaire au champ d'induction magnétique **B** puisque ce dernier est sensiblement orienté suivant l'axe de déplacement du substrat 1 à traiter et la tension de gaine 16 étant élevée, la composante perpendiculaire du vecteur vitesse de l'électron $v_{perp}$ est toujours

beaucoup plus élevée que sa composante parallèle au champ d'induction magnétique $v_{para}$ puisque cette dernière correspond sensiblement à la vitesse thermique moyenne des électrons dans le plasma correspondant à une énergie cinétique beaucoup plus faible. L'énergie thermique moyenne de l'électron est typiquement inférieure à 10 eV dans ce type de plasma. Ceci explique pourquoi le confinement magnétique des électrons secondaires reste très efficace jusqu'à ce qu'ils perdent dans des collisions inélastiques la presque totalité de l'énergie gagnée lors de leur accélération dans la gaine cathodique 16. Ces électrons rebondissent ainsi entre les miroirs magnétiques jusqu'à épuisement de l'énergie gagnée dans la gaine 16.

La tension de la gaine 16 est typiquement de l'ordre de plusieurs centaines de Volt.

Outre ce mouvement longitudinal, les électrons décrivent aussi un mouvement dans une direction perpendiculaire au champ d'induction et dans une direction perpendiculaire au champ électrique, autour du substrat 1 (voir la Fig. 16). Ces électrons décrivent ainsi, finalement, une trajectoire en spirale 17 autour du substrat 1 à nettoyer en rebondissant de manière continue entre les miroirs magnétiques jusqu'à l'épuisement de l'énergie gagnée lors de l'accélération dans la gaine 16. On réalise en fait une décharge magnétron confinée entre deux miroirs successifs autour du substrat 1 à nettoyer ou à chauffer. Seuls les électrons dont l'angle d'échappement θ est inférieur à l'angle critique $θ_{cr}$ peuvent s'échapper de la zone de confinement dans une proportion dépendant encore une fois du rapport des champs d'induction $B_{min}$ entre les miroirs et $B_{max}$ au niveau des miroirs. En effet, seul des électrons "thermalisés" au cours de nombreuses collisions peuvent s'échapper au travers des miroirs magnétiques. Par électrons "thermalisés" on comprend des électrons dont l'énergie cinétique est diminuée et a atteint la valeur moyenne de l'énergie de la distribution énergétique des électrons dans la décharge électrique. Il est donc possible de placer les contre-électrodes ou les anodes au niveau des miroirs magnétiques sans risque de capter des électrons secondaires avant thermalisation. On peut montrer que la fraction $F_{th}$ des électrons totalement thermalisés qui sont piégés entre les miroirs magnétiques vaut :

$$F_{th} = (1-B_{min}/B_{max})^{1/2}$$

(J. R. Roth, Industrial Plasma Engineering, Vol. 1, IOP Publishing (1995), ISBN 0 7503 0318 2).

Différentes configurations particulières sont possibles pour le confinement des électrons, et par conséquent pour le confinement du plasma, vers la surface extérieure du substrat :

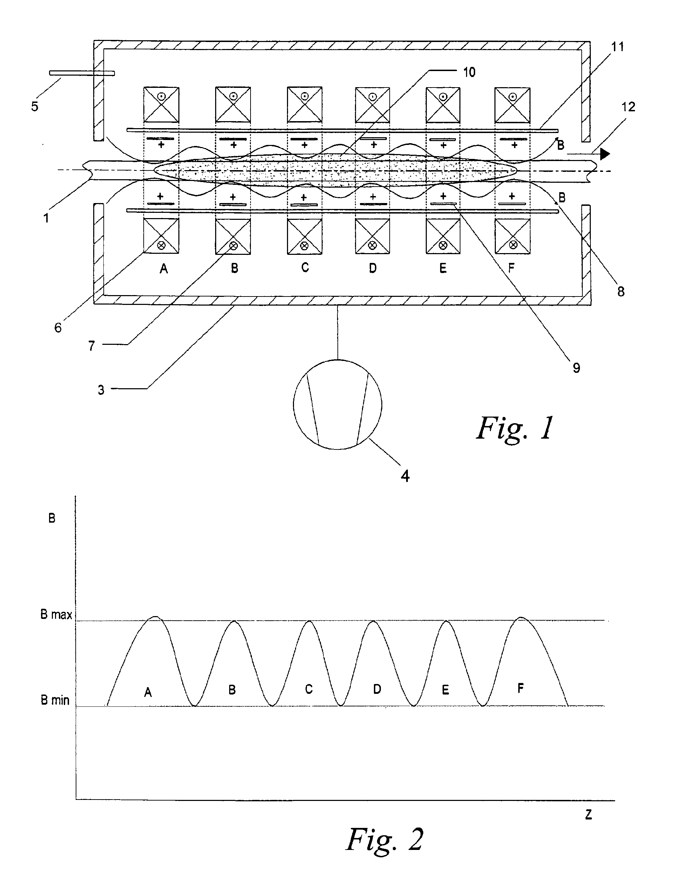

Une première méthode consiste à confiner la décharge dans la direction perpendiculaire à l'axe de déplacement du substrat entre deux miroirs voisins, par la présence d'un champ magnétique axial, comme représenté aux figures 1, 5 et 7. Ce dernier permet de réduire le coefficient de diffusion ambipolaire $D_{perp(a)}$ du plasma dans la direction perpendiculaire à l'axe de défilement à la valeur du coefficient de diffusion $D_{perp(e)}$ des électrons dans cette même direction, cette valeur étant beaucoup plus faible que la valeur du coefficient de diffusion ambipolaire d'une décharge non magnétisée $D_a$. Voir [M. A. Lieberman, A. J. Lichtenberg in Principles of Plasma Discharges and Material Processing, Wiley Interscience, ISBN 0471005770, NY(1994), pp 129-145].

La présence du champ d'induction magnétique suivant la direction du déplacement du substrat, limite en effet la diffusion du plasma dans la direction transversale à la direction de déplacement du substrat perpendiculaire aux lignes de champ d'induction magnétique en forçant les électrons à tourner autour de la même ligne de champ tant qu'une collision avec une autre particule, comme par exemple un atome ou une molécule du gaz, n'a pas eu lieu. Cette configuration a aussi l'avantage de générer une décharge magnétron autour du substrat traité et donc a encore pour effet d'améliorer le confinement du plasma autour du substrat. Deux miroirs magnétiques générant un champ dans le même sens permettent de réaliser cette configuration.

Pour générer une telle décharge magnétron, le champ d'induction magnétique parallèle à l'axe de défilement du substrat est avantageusement au moins égal à $10^{-3}$ T (1 T = 1 tesla) et est de préférence compris entre $10^{-3}$ T et 0,25 T dans la zone de traitement.

Dans une forme de réalisation préférentielle de l'invention, on renforce le champ d'induction magnétique suivant la direction de déplacement du substrat par d'autres moyens tel que par exemple par adjonction d'un troisième solénoïde entre les deux miroirs magnétique ou par la présence d'aimants permanents entre les miroirs.

Il est aussi possible de pourvoir la zone de traitement seulement d'un champ d'induction magnétique parallèle à la direction de déplacement du substrat sans qu'il soit nécessaire d'installer des miroirs magnétiques si la zone de traitement est suffisamment longue pour que les pertes en plasma à l'entrée et à la sortie de cette zone soient faibles par rapport à la production du plasma dans cette même zone.

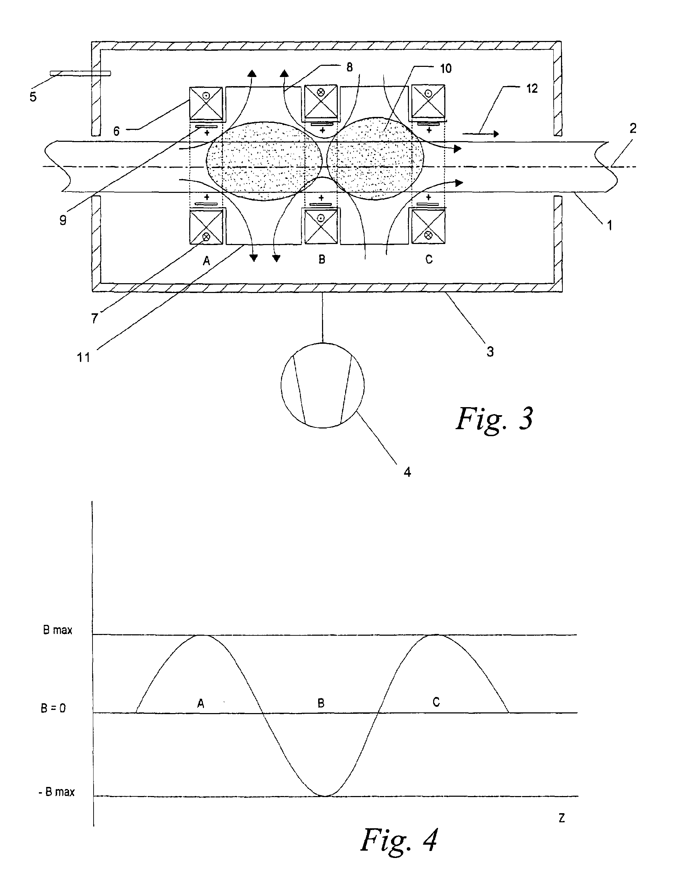

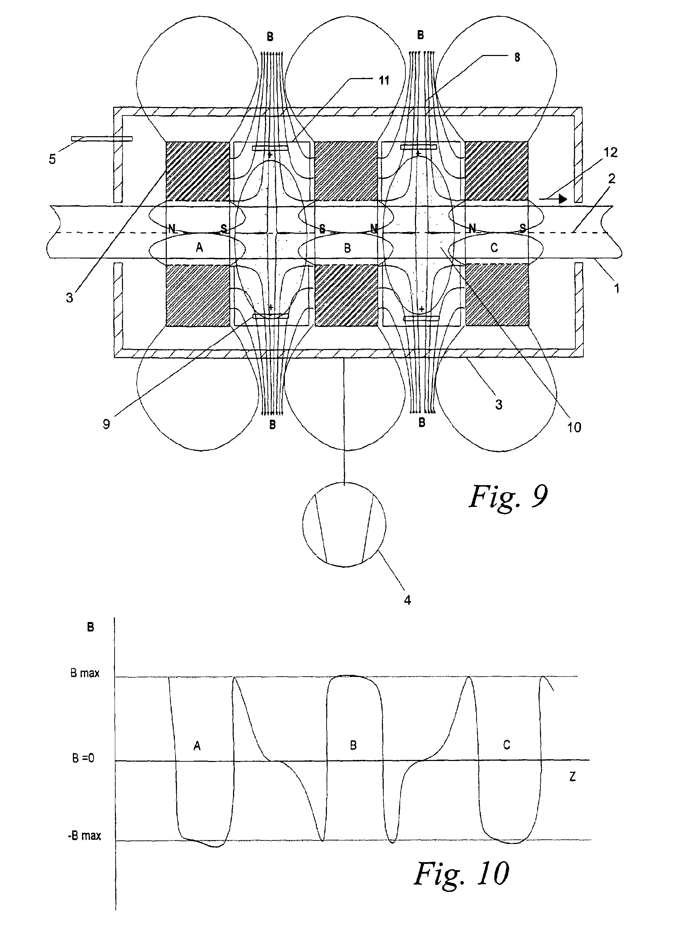

Une seconde méthode consiste à confiner les électrons secondaires dans l'espace délimité par deux miroirs en faisant usage d'une configuration particulière de ces derniers, connue sous le nom de point de rebroussement magnétique ou "magnetic cusp" comme représenté dans les figures 3 et 9. Dans ce cas, les champs parallèles à l'axe de défilement, produits par deux miroirs voisins s'inversent en un point de rebroussement, ce qui a pour effet de produire une zone de confinement pour les électrons aussi bien dans la direction de déplacement du substrat que dans la direction perpendiculaire à cette direction.

En effet, cette configuration a l'avantage de générer un miroir magnétique autour du substrat dans la zone de traitement en plus des miroirs magnétiques traversés par le produit. La composante parallèle à l'axe de défilement du champ d'induction magnétique s'annule au point de rebroussement Voir [J. R. Roth, Industrial Plasma Engineering, Vol. 1, IOP Publishing (1995), ISBN 0 7503 0318 2, p 83].

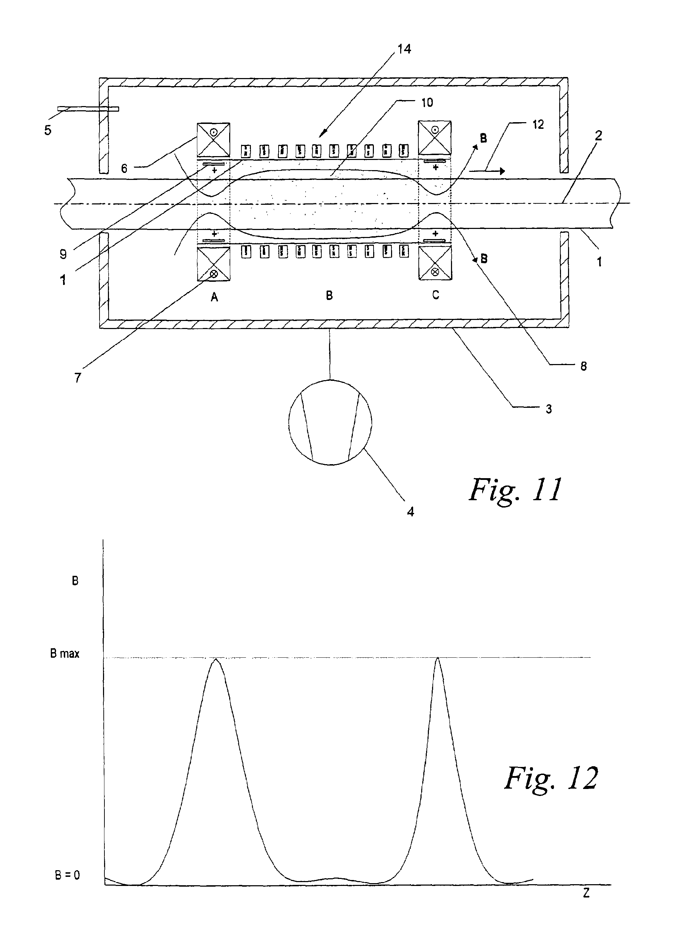

Une troisième méthode fait usage d'un confinement magnétique multipolaire sur une surface de révolution entourant le substrat à traiter entre les deux miroirs magnétiques traversés par ce dernier. Ce confinement multipolaire peut être réalisé, par exemple, par juxtaposition d'aimants permanents comme représenté dans la figure 11.

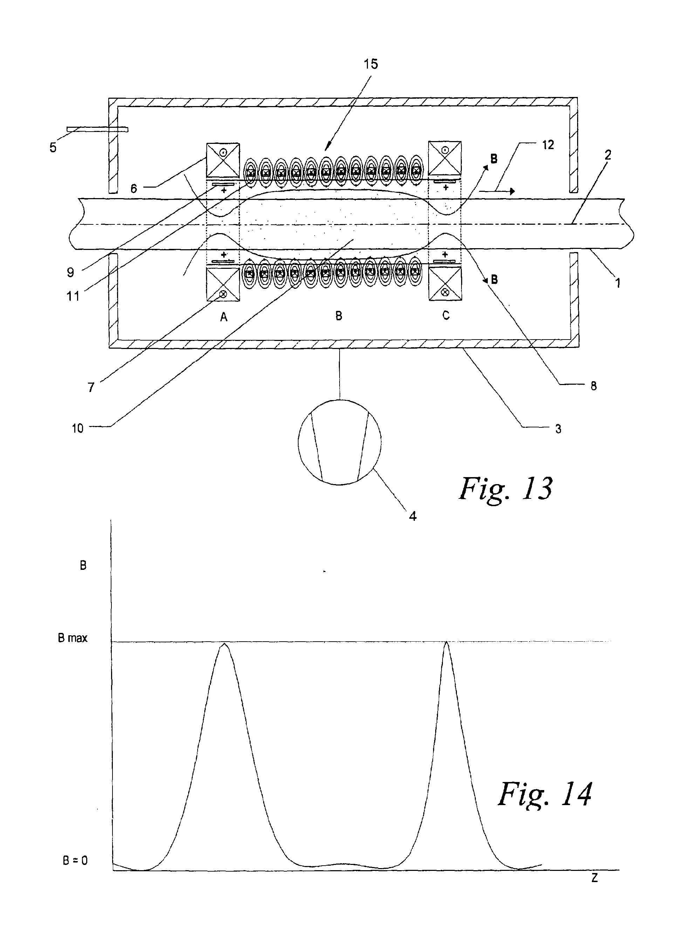

Une autre méthode connue consiste à faire passer dans des solénoïdes serrés, entourant le produit, et espacées les uns des autres, des courants en sens inverses (Fig. 13). Ces solénoïdes peuvent être réduits à des fils entourant le produit, parcourus par des courants successivement en sens inverses. Voir [J. R. Roth, Industrial Plasma Engineering, Vol. 1, IOP Publishing (1995), ISBN 0 7503 0318 2, p. 88-90] et [M. A. Lieberman, A. J. Lichtenberg in Principles of Plasma Discharges and Material Processing, Wiley Interscience, ISBN 0471005770, NY(1994), pp 146-150].

Un grand avantage du procédé, selon l'invention, est qu'il permet, contrairement aux procédés de décapage ou "d'etching" magnétron classiques, de réaliser une décharge magnétron autour de substrats de sections transversales de formes différentes. Le procédé convient, par exemple, pour le nettoyage de substrats qui sont constitués de poutrelles en formes de T, I ou U, de fils ou de multitudes de fils, de bandes, de tôles, etc. Il permet aussi de traiter les bords de tôle. Le procédé, suivant l'invention, ne nécessite en effet pas la présence d'aimants permanents placés à l'arrière du substrat, ainsi que des dispositifs mécaniques compliqués pour réaliser les adaptations aux différentes largeurs de bandes. Voir par exemple : EP535568, EP780485, EP879897, D136047, EP878565, EP908535, [S. Schiller, U. Heisig, K. Steinfelder and K. Gehn, Thin Solid Films, 51(1978)191].

Le procédé peut être utilisé pour nettoyer la surface extérieure d'un produit par bombardement d'ions provenant du plasma. Dans ce cas, pour que la cinétique de nettoyage soit élevée, il est préférable de travailler à une pression suffisamment basse, de préférence à une pression en-dessous de 1 Pa, de manière à ce que les ions accélérés dans la gaine cathodique ne subissent pas de collision avant impact avec la surface du substrat.

Pour nettoyer le substrat une décharge électrique est générée dans un gaz maintenu avantageusement à une pression inférieure à 1 Pa et de préférence comprise entre 1 Pa et 0,01 Pa dans la zone de traitement.

Lorsque le procédé est utilisé en vue de réchauffer un produit métallique et que l'on veut éviter l'érosion de la surface extérieure par le bombardement d'ions, il est préférable de travailler à une pression telle que les ions subissent de nombreuses collisions avec les atomes ou molécules du gaz durant leur accélération dans la gaine cathodique. Dans ce cas, l'énergie étant apportée à la surface du substrat par un plus grand nombre de particules, ce dernier est beaucoup moins érodé. En effet, les particules, qui arrivent sur la surface extérieure du produit métallique, n'ont pas une énergie cinétique suffisante pour pulvériser les atomes superficiels. En général, dans un procédé de chauffage on travaille à une pression au-dessus de 1 Pa, et de préférence à une pression de l'ordre de 10 Pa.

Pour chauffer le substrat, une décharge électrique est produite dans un gaz maintenu avantageusement entre 10 Pa et 1000 Pa.

La Figure 1 représente une première forme de réalisation du dispositif, selon l'invention, dans lequel un substrat 1 est déplacé suivant un axe de déplacement 2 dans le sens de la flèche 12 à travers une cuve 3, constituant une chambre à vide, connectée à un groupe de pompage 4. Le groupe de pompage 4 permet de maintenir un gaz à basse pression dans la cuve 3. Un tube 5 traverse la paroi de la cuve 3 afin de pouvoir injecter un gaz ou un mélange gazeux dans cette dernière, nécessaire au procédé de nettoyage ou de chauffage.

Dans ce cas particulier, le dispositif est pourvu de six solénoïdes 6 (A,B,C, D, E, et F) coaxiaux qui se trouvent à l'intérieur de la cuve 3 et qui permettent de créer un champ d'induction magnétique B au centre des solénoïdes 6, sensiblement parallèle à l'axe de déplacement 2.

Le profil général des lignes de champ d'induction magnétique créé par les solénoïdes 6 est indiqué par la ligne 8.

A l'intérieur de chacun des solénoïdes 6 est agencé une contre-électrode 9 de section rectangulaire ou cylindrique de sorte qu'elle entoure toute la surface du substrat 1.

Dans l'espace entre les solénoïdes 6 et les contres-électrodes 9 est monté une enceinte de confinement électrostatique 11 permettant l'isolation électrique par rapport aux parois de la cuve 3. Cette enceinte de confinement électrostatique 11 est isolée électriquement du substrat 1 et de la cuve 3 et est donc maintenue à potentiel flottant par rapport au potentiel du substrat 1 et par rapport au potentiel de la cuve 3. Ainsi on évite la formation d'une décharge sur les parois de la cuve 3 et les solénoïdes 6 sont protégés vis-à-vis de la matière éliminée du substrat 1 lors du nettoyage. Cette enceinte 11 permet d'ailleurs la récupération du métal arraché au substrat par le bombardement d'ions. Elle est de préférence d'allure tubulaire.

Une décharge 10 est réalisée entre le substrat 1 et les contres-électrodes 9. Le champ d'induction magnétique B, généré au moyen des solénoïdes 6 parcourus par des courants électriques de même sens, comme indiqué par l'orientation de la flèche 7 qui est perpendiculaire au plan de la figure 1, est sensiblement parallèle à l'axe de déplacement 2. Il en résulte que l'orientation du champ d'induction B est sensiblement constante. L'intensité de ce dernier varie suivant l'axe de déplacement 2. La flèche 7 représente le vecteur courant vu par une de ses extrémités.

Le champ d'induction est maximum et a une valeur $B_{max}$ au niveau de chaque solénoïde et il présente un minimum ($B_{min}$) entre deux solénoïdes 6 successifs comme le montre clairement la figure 2.

Par conséquent, les électrons sont généralement confinés entre deux solénoïdes 6 successifs tant que l'angle d'échappement θ reste supérieur à l'angle d'échappement critique $θ_{cr}$. Les solénoïdes sont suffisamment proches pour permettre la présence d'un champ d'induction minimum $B_{min}$, parallèle à l'axe de déplacement 2, non nul. Il en résulte qu'une décharge magnétron s'établit autour du produit à traiter entre deux solénoïdes successifs.

La forme de réalisation du dispositif, selon l'invention, représentée à la figure 3 est différente de la forme de réalisation précédente en ce qu'une décharge est réalisée entre trois solénoïdes 6 parcourus par un courant circulant successivement en sens inverse. Dans ce cas, le champ d'induction magnétique 8 ne reste sensiblement parallèle à l'axe de déplacement 2 qu'au niveau des solénoïdes 6. Entre deux solénoïdes successifs, il est transversal à l'axe de déplacement 2. Le champ d'induction magnétique 8 est donc maximum, en valeur absolue, au centre des solénoïdes A, B et C. Par contre le champ parallèle à l'axe de déplacement 2 s'annule rapidement entre deux solénoïdes au voisinage du produit comme montré à la figure 4. Cette configuration permet la formation d'un miroir magnétique autour du produit 1 entre deux solénoïdes successifs comme le montre clairement la figure 3 par la concentration des lignes de champ 8 autour du produit entre deux solénoïdes successifs.

Le plasma 10 est, par conséquent, également confiné suivant une direction perpendiculaire à l'axe 2 car l'intensité du champ d'induction magnétique dans cette direction augmente du fait de l'inversion du champ produit par 2 solénoïdes successifs. Le plasma est donc confiné dans une zone délimitée par deux solénoïdes 6 successifs qui forment, d'une part, des miroirs magnétiques perpendiculairement à l'axe de déplacement, et d'autre part, un miroir magnétique entourant le substrat 1, le miroir magnétique entourant le substrat 1 de section généralement quelconque et adaptée à la forme du produit, i.e. rectangulaire pour une bande, cylindrique pour une poutrelle ou un fil, étant situé entre deux solénoïdes successifs.

La figure 4 montre clairement la présence d'un point pour lequel le champ d'induction magnétique B parallèle à l'axe de déplacement s'annule pour s'inverser sur l'axe 2.

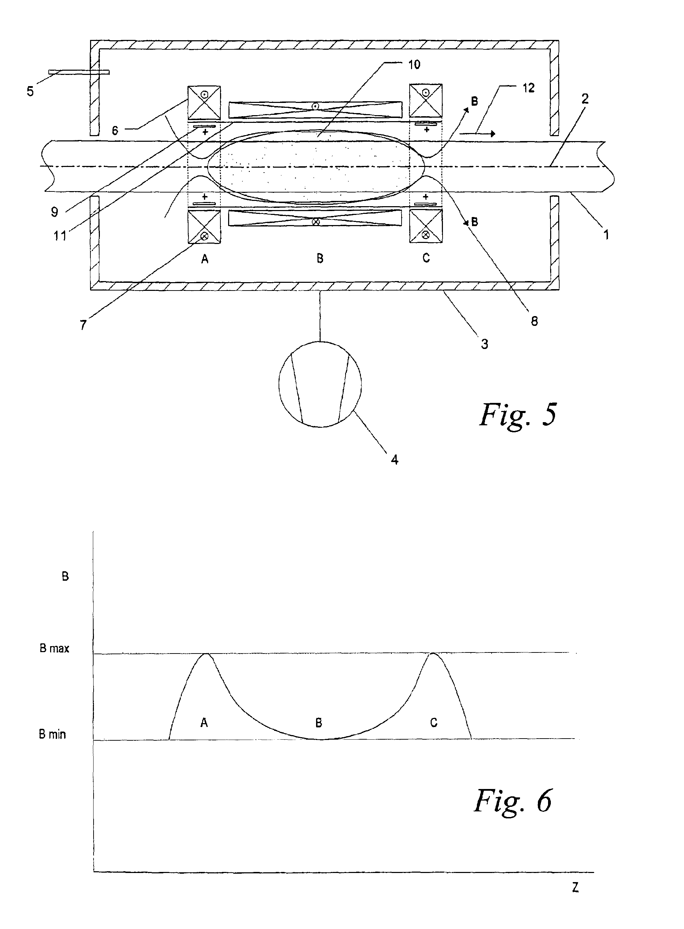

La forme de réalisation du dispositif, suivant l'invention, représentée à la figure 5 correspond au cas préférentiel où trois solénoïdes successifs A, B et C sont parcourus par un courant dans le même sens et génèrent un champ magnétique dans le même sens.

Une décharge magnétron autour du substrat 1 est produite entre deux solénoïdes 6 successifs. Les miroirs A et C, et le troisième solénoïde B permettent de produire un champ d'induction magnétique parallèle à l'axe de déplacement 2. Cette configuration est particulièrement intéressante car elle permet de réaliser une décharge magnétron autour du substrat 1 sur une longueur généralement quelconque dans des conditions relativement uniformes avec une densité de plasma élevée. L'utilisation de solénoïdes A, B et C de sections rectangulaires permet de traiter des bandes métalliques, tandis que l'utilisation de solénoïdes de sections cylindriques permet de traiter des substrats longs comme par exemple des fils, des poutrelles ou des tubes.

Les électrons de la décharge sont confinés à l'intérieur du solénoïde B par les miroirs magnétiques constitués par les solénoïdes A et C tant que l'angle de sortie θ est supérieur à l'angle critique $θ_{cr}$ (cf. supra). L'intensité de la composante du champ d'induction magnétique parallèle à l'axe de déplacement 2 est maximum au milieu des solénoïdes A et C et minimum au milieu du solénoïde B comme montré à la figure 6.

Des montages successifs de ce type peuvent être agencés les uns derrière les autres en faisant suivre chaque miroir (solénoïde A ou C) d'un solénoïde de type B permettant la décharge magnétron suivant une séquence du type: ABABABA.

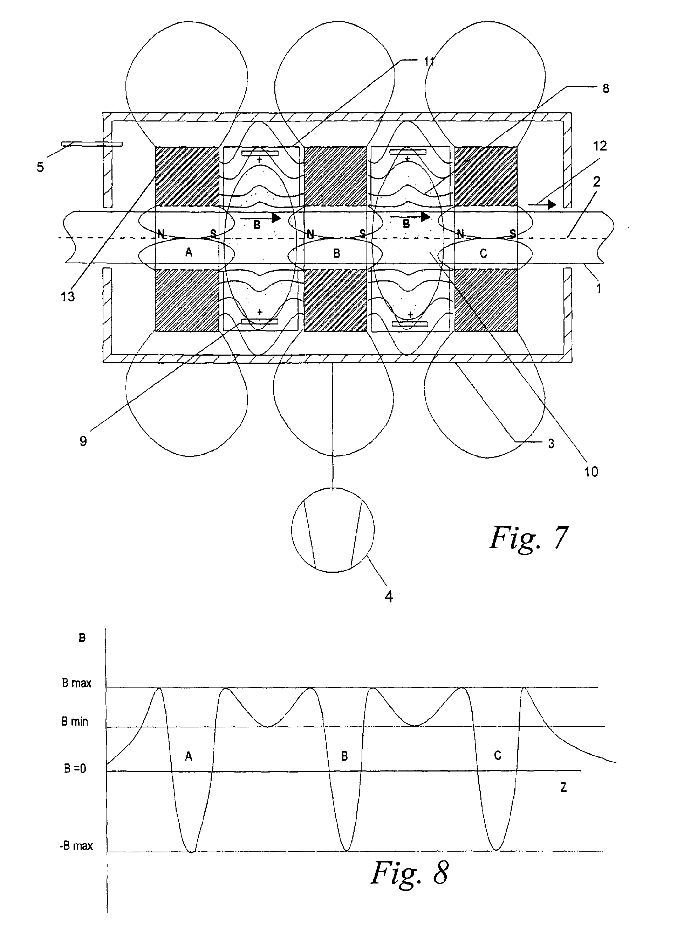

La configuration du dispositif, suivant l'invention, représentée à la figure 7 est une configuration de type bouteille magnétique réalisée non plus au moyen de solénoïdes parcourus par un courant électrique circulant dans le même sens comme montré à la figure 1, mais au moyen d'aimants permanents 13 magnétisés dans une direction parallèle au sens du déplacement 2 du produit.

Trois aimants permanents 13 sont montés suivant la direction de déplacement 2. Le pôle nord d'un des aimants est disposé face au pôle sud de l'aimant voisin. Ceci a comme conséquence qu'entre deux aimants voisins, le champ magnétique est orienté dans le même sens. Il est sensiblement parallèle à l'axe de déplacement 2 et présente une valeur minimale au milieu de la zone entre deux aimants successifs comme le montre la figure 8. Les électrons secondaires de la décharge 10 sont réfléchis par les miroirs que constituent les pôles magnétiques des aimants ou le champ magnétique est maximum et égal à $B_{max}$. La décharge est confinée entre chaque paire d'aimants successifs. Une décharge magnétron se forme autour du substrat dans chaque zone située entre deux aimants successifs. Bien entendu, le retour du champ magnétique impose une inversion du sens du champ d'induction dans le passage libre des aimants permanents permettant la traversée du produit. Cette configuration est particulièrement intéressante dans le cas du traitement de fils métalliques.

Une autre forme de réalisation du dispositif, suivant l'invention, représentée à la figure 9, diffère de celle de la figure 7 en ce que les trois aimants permanents 13 sont montés avec le pôle nord d'un des aimants orienté face au pôle nord de l'aimant voisin et inversement le pôle sud face au pôle sud de l'aimant voisin. De cette manière, un point de rebroussement de la composante parallèle du champ d'induction suivant la direction de défilement 2 peut être obtenu, comme dans le dispositif de la figure 3. On constate bien la présence d'un point d'inversion du signe de la composante parallèle à l'axe 2 du champ d'induction entre deux aimants successifs comme montré à la figure 10.

Le plasma 10 est confiné suivant l'axe 2 entre les deux surfaces magnétiques de même polarité se faisant face. Radialement le plasma 10 est confiné à cause de la formation d'un miroir magnétique sur une surface fermée entourant le produit par la concentration des lignes de champ B en s'éloignant de l'axe 2 entre deux aimants successifs.

Dans la forme de réalisation du dispositif, suivant l'invention, de la figure 11, la décharge est réalisée entre deux miroirs magnétique A et C qui permettent le confinement axial des électrons. Le confinement du plasma autour du produit est réalisé au moyen d'une série d'aimants permanents 14 disposés autour de l'enceinte électrostatique 11. Ces aimants permettent de repousser magnétiquement les électrons et donc le plasma de cette enceinte 11 vers le produit 1.

En effet, ces aimants permanents 14 constituent une série de miroirs magnétiques qui obligent les électrons à retourner en direction du substrat 1. Il va de soi que différentes dispositions des aimants sont possibles, telles que celles décrites dans la littérature [J. R. Roth, Industrial Plasma Engineering, Vol. 1, IOP Publishing (1995), ISBN 0 7503 0318 2]. Cette configuration est intéressante si l'on veut éviter la présence de tout champ magnétique dans la zone de confinement du plasma 10. Comme l'indique la figure 12, le champ magnétique est négligeable au niveau de l'axe de déplacement 2 entre les miroirs magnétiques A et C. Cette configuration permet aussi de réaliser des plasmas 10 dans des zones de grands volumes.

La configuration du dispositif montré à la figure 13 est identique à la précédente mis à part les moyens permettant de générer le champ magnétique à la surface de l'enceinte 11. En effet, dans ce cas, les aimants permanents sont remplacés par une série de solénoïdes 15 parcourus par des courants successivement en sens opposés.

La figure 14 indique que la variation du champ d'induction magnétique du dispositif de la figure 13 est analogue à celle de la figure 12.

La figure 15 représente la décharge et le comportement des électrons dans la zone de traitement située entre deux miroirs magnétiques où le champ d'induction magnétique B est égal à $B_{min}$. Les miroirs magnétiques sont disposés dans des plans perpendiculaires à l'axe de déplacement 2 du substrat 1. Ce dernier est polarisé négativement par rapport à la contre-électrode 9.

On distingue la formation d'une gaine cathodique 16 à la surface du substrat 1. Dans cette gaine 16, le champ électrique **E** permet d'accélérer les ions vers la surface du substrat. Lors de l'impact de ces derniers, les électrons secondaires émis sont accélérés vers le plasma par le même champ et il en résulte que la composante perpendiculaire $v_{perp}$, par rapport à la direction du champ B, de leur vitesse est en moyenne beaucoup plus élevée que la composante parallèle $v_{para}$ de cette même vitesse. L'angle de confinement θ est donc supérieur à l'angle de confinement critique $θ_{cr}$ tant qu'une partie significative de leur énergie n'a pas été perdue dans des collisions inélastiques. Il en résulte que ces électrons sont réfléchis dans la décharge suivant des trajectoires 17, tant que cette condition est satisfaite. La contre-électrode 9, permet le retour des électrons qui ont perdu leur énergie cinétique, et qui sont donc thermalisés, vers le générateur non représenté sur la figure.

La contre-électrode peut fonctionner comme anode en courant continu, ou successivement comme cathode et comme anode en courant alternatif. Pour éviter, dans ce cas, que cette dernière ne soit attaquée par les ions lorsque la polarisation est négative par rapport au produit, plusieurs moyens peuvent être mis en oeuvre.

Dans un premier moyen, les anodes sont placées seulement au niveau des miroirs magnétiques, c'est-à-dire dans une zone où la densité de plasma est normalement moins élevée qu'entre deux miroirs car les électrons y sont repoussés.

Un deuxième moyen consiste en la réduction du temps durant lequel la contre-électrode est polarisée négativement par rapport au temps durant lequel elle est polarisée positivement. En effet, le temps de polarisation négatif du substrat peut être beaucoup plus long que le temps de polarisation positif car les électrons se déplacent beaucoup plus vite que les ions du fait de leur masse beaucoup plus faible. Ainsi, on peut faire usage de générateurs à courants pulsés ou encore de générateurs à courants simplement redressés (non lissés). L'avantage de l'utilisation d'une décharge en courant alternatif est la forte diminution de la probabilité d'apparition d'arcs "unipolaires" sur la surface traitée par neutralisation électrique des charges se formant à la surface des impuretés diélectriques telles que des graisses et des oxydes toujours présents à la surface du produit à traiter. Ces charges se forment naturellement lors du bombardement d'ions et sont neutralisées par le flux d'électrons lorsque le produit est polarisé positivement par rapport à la contre-électrode.

On utilise typiquement un courant alternatif avec une fréquence comprise entre 10kHz et 100kHz.

En courant continu la position de l'anode est généralement indifférente. De préférence, le substrat est maintenu au potentiel de la masse de l'installation.

La figure 16 représente une vue en coupe suivant une direction transversale perpendiculaire à la direction de déplacement 2. Le champ magnétique B est donc perpendiculaire par rapport au plan de la feuille. Cette figure illustre comment les électrons se déplacent autour du substrat 1 suivant une trajectoire 17 sous l'influence conjointe du champ magnétique et du champ électrique de gaine 16. Une décharge magnétron se forme donc autour du substrat comme l'illustre la figure 16. Il en résulte que le procédé s'adapte naturellement pour toute variation d'épaisseur (th) et de largeur (w) du substrat 1.

Les électrons tournent autour des lignes de champ tandis que les ions bombardent le substrat 1. Les trajectoires 17 des électrons sont dues à la perpendicularité de la direction du champ d'induction magnétique avec la direction du champ électrique de gaine qui est toujours orienté perpendiculairement à la surface du substrat.

Tous les dispositifs de confinement magnétique peuvent indifféremment être situés à l'intérieur (comme illustré dans les différentes figures) ou à l'extérieur de la cuve 3. Dans ce dernier cas, la cuve 3 doit être réalisée en un matériau non-ferromagnétique tel qu'un acier inoxydable ou de l'aluminium pour permettre la pénétration du champ d'induction magnétique à l'intérieur de la cuve 3.

Pour la même raison, l'enceinte de confinement 11 doit également être réalisée en un matériau non-ferromagnétique.

Exemples d'applications pratiques

1. Nettoyage de tôles d'acier doux laminées à chaud

Un dispositif de nettoyage de tôles d'acier doux laminées à chaud à été réalisé suivant la configuration présentée à la figure 5.

Dans ce dispositif, les trois solénoïdes A, B et C de sections transversales perpendiculaires à l'axe de déplacement 2, de formes rectangulaires sont de mêmes dimensions. La longueur de chaque solénoïde est de 400 mm, tandis que la dimension moyenne de la section rectangulaire est de 400 mm par 1000 mm. Chaque solénoïde est constitué par bobinage de fil de cuivre.

Les deux solénoïdes extérieurs constituant les miroirs magnétiques A et C consomment une puissance électrique de 2,240 kW chacun. Le solénoïde central est alimenté par un courant continu de 0,7 A sous 800 V, soit une puissance électrique consommée de 560 W. La puissance électrique totale consommée pour générer le champ d'induction B est donc environ de 5 kW. Les trois solénoïdes sont disposés dans des carcasses étanches perméables au champ magnétique entourant le produit à l'intérieur de la cuve 3.

Cette configuration permet d'obtenir un champ maximum $B_{max}$ de $5.10^{-2}$ T et un champ d'induction minimum $B_{min}$ valant $2,5 \ 10^{-2}$ T dans la zone centrale où une décharge magnétron est réalisée autour du substrat dans de l'argon maintenu à une pression de 0,5 Pa (5 mbar).

Dans ces conditions, la tension entre anode et cathode est de l'ordre de 500 V pour un courant électrique de 304 A, soit une puissance électrique consommée de 152 kW dans la décharge.

Il en résulte une puissance moyenne dissipée à la surface du substrat, constituant la cathode du système, par bombardement d'ions d'argon de l'ordre de 19 W/cm$^2$, ce qui correspond à une densité électronique dans le plasma de $1,14 \times 10^{12}$ cm$^{-3}$. L'angle critique d'échappement des électrons $\theta_{cr}$ vaut 45° dans ces conditions car $\sin\theta_{cr} = (250/500)^{1/2}$.

Les électrons secondaires accélérés dans la gaine sont donc largement confinés par les miroirs magnétiques avant collisions inélastiques, l'angle d'échappement $\theta$ juste après accélération valant en effet 84°, ce qui est supérieur à 45°. On peut aussi montrer que dans ces conditions 71% des électrons "thermalisés" sont confinés entre les deux miroirs magnétiques A et C.

Le retour de courant vers les contres-électrodes placées au niveau des miroirs A et C est donc dû aux électrons dont l'angle d'échappement est inférieur à 45° ce qui correspond à 29% de la population des électrons "thermalisés". Le rayon de giration des électrons secondaires accélérés sous 500 V vaut 3 mm et dépasse donc la valeur de l'épaisseur de la gaine cathodique qui est de l'ordre de 0,5 mm à la surface du substrat.

Les ions bombardent la surface du substrat après accélération dans la gaine, et sans subir de collision au cours de cette accélération, quasiment à incidence normale.

Quatre dispositifs du type précédent permettaient un nettoyage de la tôle suffisant à une vitesse de 100 m/min pour assurer une excellente adhérence à un dépôt d'épaisseur de 7 μm de zinc réalisé par "ion plating" sur les deux faces d'une tôle d'un millimètre d'épaisseur, dont la température n'excédait pas une centaine de degrés centigrades après traitement.

La tôle était maintenue à la masse alors que les contres-électrodes étaient alimentées en courant pulsé à 40 kHz. Ces dernières constituaient les anodes du système durant la plus grande partie du cycle en tension. Durant cette phase anodique des contres-électrodes, la surface de la tôle était bombardée par les ions d'argon, tandis que la courte phase cathodique des contres-électrodes permettait de neutraliser les charges positives à la surface de la tôle et assurait ainsi une décharge sans arc électrique.

Le même dispositif permettait de traiter des tôles de largeurs inférieures et d'épaisseurs différentes sans aucune modification du dispositif, si ce n'est l'adaptation des puissances électriques consommées.

Une série de fils ou bandes parallèles pouvaient d'ailleurs être traités sans autre modification du procédé de nettoyage qu'une adaptation de la puissance électrique en fonction du produit traité.

2. Chauffage d'une tôle d'acier laminée à froid dans un processus de recuit sous vide par plasma froid.

Le même dispositif que celui décrit au point précédent comprenant quatre unités de trois solénoïdes successifs, munis chacun d'anodes au milieu des miroirs magnétiques, a permis de réchauffer une tôle de 1 m de largeur et de 0,18 mm d'épaisseur à une température de 600°C à une vitesse de 100 m/min, avant refroidissement à basse pression sur des rouleaux de refroidissement métalliques eux-mêmes refroidis à l'eau. Pour éviter une érosion excessive de la tôle par le bombardement d'ions, la pression d'argon était maintenue à 10 Pa. Chacune des quatre unités de chauffage consommait une puissance de 180 kW, ce qui correspondait à une puissance totale de 720 kW. La densité de puissance dissipée dans la zone de traitement était de 22,5 W/cm$^2$. Les quatre unités de chauffage étant réparties sur 8 m, on estime la vitesse moyenne de montée en température à 125°C/s. En modifiant le nombre d'unités de chauffage et la puissance consommée par les unités de chauffage on pouvait modifier à la fois la valeur de la température à atteindre et la vitesse de montée en température. Le même dispositif permettait de traiter des tôles de largeurs inférieures et d'épaisseurs différentes sans aucune modification au dispositif si ce n'est l'adaptation des puissances électriques consommées.

3. Nettoyage d'un fil d'acier doux avant zingage

Un fil d'acier doux a été nettoyé au moyen d'un dispositif tel que celui présenté à la figure 7. Le fil traversait onze unités de traitement délimitées chacune par une paire d'aimants permanents NeFeB. La longueur utile de chaque zone de traitement était de 10 cm, soit 1,1 m de longueur de traitement utile au total. Pour un fil d'acier d'un diamètre de 5 mm, défilant avec une vitesse de 300 m/min, un nettoyage efficace avant zingage par "ion plating" était fait à une pression d'argon de 0,5 Pa en consommant une puissance électrique de l'ordre de 15 kW. La densité de puissance moyenne était dans ce cas de 90 W/cm$^2$ et l'élévation de température du fil restait inférieure à 40 K.

Comme illustré dans la description, la présente invention a dans tous les cas comme avantage principal de permettre l'obtention d'une décharge confinée magnétiquement autour de la surface extérieure d'un substrat métallique au défilé permettant ainsi un traitement continu de toute sa surface extérieure, quelque-soit la forme ou la variation de forme de ce substrat en cours de procédé. Seule l'adaptation en puissance doit être réalisée.

Dans une configuration particulièrement intéressante du procédé suivant l'invention, la présence d'un champ d'induction parallèle au produit permet, en plus du confinement de la décharge autour du produit, la réalisation d'une décharge magnétron de haute densité autour de ce dernier. Dans ce cas il est clair que l'utilisation de miroirs magnétiques est utile pour limiter les pertes plasma en entrée et sortie de la zone du traitement mais pas indispensable.

Il est bien entendu que l'invention n'est pas limitée aux différentes formes de réalisation du procédé et du dispositif décrites ci-dessus et représentées aux figures annexées, mais que bien des variantes peuvent être envisagées en ce qui concerne notamment la construction et la forme de la cuve 3, la position et la forme des solénoïdes ou des aimants permanents, et le nombre des miroirs magnétiques sans sortir du cadre de cette invention.

**Revendications**

1. Procédé de traitement, notamment de nettoyage et/ou de chauffage, d'un substrat métallique (1) défilant d'une manière sensiblement continue dans une chambre à vide (3) présentant une zone de traitement dans laquelle une décharge électrique (10), c. à.d. un plasma, et un champ magnétique sont produits dans un gaz maintenu à une pression inférieure à la pression atmosphérique entre au moins le substrat (1), formant une électrode, et au moins une contre-électrode (9) afin que le substrat (1) puisse être bombardé par des ions produits dans la décharge électrique (10), **caractérisé en ce qu'**un champ d'induction magnétique de confinement est réalisé tout autour du substrat (1) dans la zone de traitement de sorte que la décharge électrique (10) est également confinée tout autour du substrat (1) dans cette zone de traitement par le confinement d'électrons libérés dans la décharge électrique (10).

2. Procédé suivant la revendication 1, **caractérisé en ce que** l'on réalise dans la zone de traitement précitée un champ d'induction magnétique sensiblement parallèle à l'axe de défilement (2) du substrat (1) dans cette zone de traitement d'une manière telle à permettre ainsi la formation d'une décharge magnétron autour du substrat (1) par une circulation d'électrons de la décharge selon des trajectoires (17) s'étendant autour du substrat (1).

3. Procédé suivant l'une ou l'autre des revendications 1 et 2, **caractérisé en ce que** l'on réalise un champ d'induction magnétique dont la composante parallèle à l'axe de défilement (2) est au moins égale à 10$^{-3}$ T (10 Gauss) et de préférence comprise entre 10$^{-3}$ T (10 Gauss) et 0,25 T (2500 Gauss) dans la zone de traitement précitée.

**4.** Procédé suivant la revendication 1, **caractérisé en ce que** l'on réalise, dans la zone de traitement, au moins un miroir magnétique tout autour du substrat.

**5.** Procédé suivant la revendications 4, **caractérisé en ce qu'**un champ d'induction magnétique sensiblement transversal à l'axe de défilement (2) du substrat (1) est généré dont l'intensité augmente au moins d'un facteur deux depuis le substrat (1) jusqu'au miroir magnétique.

**6.** Procédé suivant l'une quelconque des revendications 1 à 5, **caractérisé en ce que** l'on réalise au moins deux miroirs magnétiques qui sont traversés par le substrat (1) et qui définissent l'entrée et la sortie de la zone de traitement, afin de confiner la décharge électrique dans une direction sensiblement parallèle à l'axe de défilement du substrat (1) dans la zone de traitement.

**7.** Procédé suivant la revendication 6, **caractérisé en ce qu'**un champ d'induction magnétique est formé par lesdits miroirs magnétiques qui est sensiblement parallèle à l'axe de défilement du substrat (1) dont l'intensité décroît en s'éloignant de chaque miroir vers le centre de la zone de traitement.

**8.** Procédé suivant l'une quelconque des revendications 6 et 7, **caractérisé en ce que** l'on produit un champ d'induction magnétique au milieu des miroirs magnétiques supérieur à toute valeur du champ d'induction magnétique dans une direction sensiblement parallèle à l'axe de défilement dans la zone de traitement, et, de préférence, au moins égal à deux fois la valeur du champ d'induction magnétique minimal dans la zone de traitement au voisinage du substrat (1).

**9.** Procédé suivant l'une quelconque des revendications 6 à 8, **caractérisé en ce que** le champ d'induction maximum produit par un miroir magnétique est au moins égal à $5.10^{-3}$ T (50 Gauss).

**10.** Procédé suivant l'une quelconque des revendications 1 à 9, **caractérisé en ce que** l'on applique une tension continue entre le substrat (1) formant une électrode et la contre-électrode (9) de manière à ce que le substrat (1) soit polarisé négativement par rapport à cette contre-électrode (9).

**11.** Procédé suivant l'une quelconque des revendications 1 à 9, **caractérisé en ce que** l'on applique une tension alternative entre le substrat (1) formant une électrode et la contre-électrode (9).

**12.** Procédé suivant la revendication 11, **caractérisé en ce que** l'on applique une tension alternative à une fréquence comprise entre 1 kHz et 1 MHz et de préférence entre 10 kHz et 100 kHz entre le substrat (1) et la contre-électrode (9).

**13.** Procédé suivant l'une ou l'autre des revendications 11 et 12, **caractérisé en ce que** l'on polarise la contre-électrode (9) négativement par rapport au substrat (1) pendant un temps plus court que le temps durant laquelle elle est polarisée positivement.

**14.** Procédé suivant l'une quelconque des revendications 1 à 13, **caractérisé en ce que**, pour chauffer le substrat (1), une décharge électrique est produite dans un gaz maintenu à une pression supérieure ou égale à 1 Pa (0,01 mbar) et de préférence comprise entre 10 Pa (0,1 mbar) et 1000 Pa (10 mbar).

**15.** Procédé suivant l'une quelconque des revendications 1 à 13, **caractérisé en ce que**, pour nettoyer le substrat (1) par un bombardement d'ions positifs, une décharge électrique est générée dans un gaz maintenu à une pression inférieure à 1 Pa (0,01 mbar) et de préférence comprise entre 1 Pa (0,01 mbar) et 0,01 Pa ($10^{-4}$ mbar) dans la zone de traitement précitée.

**16.** Procédé suivant l'une quelconque des revendications 1 à 15, **caractérisé en ce que** l'on réalise la décharge électrique dans un gaz rare, tel que de l'argon ou de l'hélium et/ou un gaz moléculaire tel que de l'hydrogène, de l'azote, de l'oxygène et/ou des composés hydrocarbonés.

**17.** Procédé suivant l'une quelconque des revendications 1 à 16, **caractérisé en ce que** l'on produit une décharge électrique entre la contre-électrode (9) et le substrat (1) sous une différence de potentiel maximale maintenue entre la contre-électrode (9) et le substrat (1) inférieure ou égale à 1000 V pour des densités de puissance moyennes par unité de surface extérieure de substrat (1) comprises entre 1 Wcm$^{-2}$ et 200 Wcm$^{-2}$.

**18.** Dispositif pour le traitement d'un substrat métallique, notamment pour la mise en oeuvre du procédé suivant l'une quelconque des revendications 1 à 17, comprenant une chambre à vide (3) dans laquelle peut défiler un substrat (1) métallique d'une manière sensiblement continue, une zone de traitement, dans laquelle est créée une décharge électrique, des moyens magnétiques de confinement d'électrons produits dans la décharge électrique, et au moins une contre-électrode (9) disposée en regard du substrat (1) formant une électrode permettant de créer cette décharge électrique, **caractérisé en ce que** les moyens magnétiques de confinement sont disposés d'une manière telle par rapport au substrat (1) pour que les ions produits dans la décharge électrique puissent se maintenir tout autour du substrat (1) et ainsi bombarder la surface de ce dernier.

19. Dispositif suivant la revendication 18, **caractérisé en ce qu'**au moins un miroir magnétique est disposé autour de la zone de traitement dans laquelle défile le substrat (1), d'une manière telle à réfléchir et renvoyer vers le substrat (1) les électrons s'éloignant de ce dernier et, par conséquent, à confiner la décharge électrique autour du substrat (1) dans cette zone.

20. Dispositif suivant la revendication 19, **caractérisé en ce que** ledit miroir magnétique est réalisé par une juxtaposition d'au moins deux solénoïdes (6) successifs pouvant être traversés par le substrat (1) et disposés suivant l'axe de défilement du substrat (1), parcourus par des courants électriques successivement de sens opposé.

21. Dispositif suivant la revendication 19, **caractérisé en ce que** ledit miroir magnétique est réalisé par au moins deux aimants successifs magnétisés dans un sens opposé suivant la direction de défilement du substrat (1) et présentant une ouverture pouvant être traversée par le substrat (1).

22. Dispositif suivant la revendication 19, **caractérisé en ce que** ledit miroir magnétique est réalisé par une série d'aimants disposés autour de la zone de traitement l'un à côté de l'autre d'une manière telle à pouvoir réfléchir les électrons vers le substrat, et magnétisés dans une direction transversale à la direction de défilement du substrat (1).

23. Dispositif suivant l'une ou l'autre des revendications 21 et 22, **caractérisé en ce que** les aimants sont constitués d'un assemblage d'aimants magnétisés suivant la même direction et suivant le même sens.

24. Dispositif suivant l'une quelconque des revendications 18 à 23, **caractérisé en ce qu'**il comprend, autour de la zone de traitement, au moins un solénoïde (6) d'axe sensiblement parallèle à l'axe de défilement du substrat (1).

25. Dispositif suivant l'une quelconque des revendications 18 à 24, **caractérisé en ce qu'**il comprend au moins deux miroirs magnétiques délimitant la zone de traitement dans la direction de défilement du substrat (1).

26. Dispositif suivant la revendication 25, **caractérisé en ce qu'**il comprend au moins deux aimants successifs magnétisés dans le même sens suivant la direction du défilement du substrat (1) et présentant une ouverture pouvant être traversée par ce substrat (1).

27. Dispositif suivant la revendication 25, **caractérisé en ce qu'**il comprend au moins deux aimants successifs magnétisés dans un sens opposé suivant la direction de défilement du substrat (1) et présentant une ouverture pouvant être traversée par le substrat (1).

28. Dispositif suivant la revendication 25, **caractérisé en ce qu'**il comprend, au moins deux solénoïdes (6) pouvant créer un champ d'induction magnétique suivant la direction de défilement du substrat (1), et étant disposés autour de l'axe de défilement de ce substrat (1) de sorte à pouvoir être traversés par le dernier.

29. Dispositif suivant l'une quelconque des revendications 18 à 28, **caractérisé en ce que** ladite contre-électrode (9) est disposée sensiblement au voisinage des miroirs magnétiques pouvant être traversés par le substrat (1).

30. Dispositif suivant l'une quelconque des revendications 18 à 29, **caractérisé en ce que** la chambre à vide (3) comprend une enceinte de confinement (11) délimitée par des parois en matériau non-ferromagnétique qui est isolée électriquement du substrat (1) et de la contre-électrode (9).

31. Dispositif suivant la revendication 30, **caractérisé en ce que** les moyens magnétiques de confinement sont disposés à l'extérieur de l'enceinte de confinement (11) entre la paroi extérieure de cette dernière et la paroi intérieure de la chambre à vide (3).

32. Dispositif suivant l'une quelconque des revendications 18 à 30, **caractérisé en ce que** les moyens magnétiques de confinement sont situés à l'extérieur de la chambre à vide, dont les parois sont alors constituées en matériaux non-ferromagnétiques.

*Fig. 1*

*Fig. 2*

*Fig. 3*

B max

B = 0

- B max

A          B          C

z

*Fig. 4*

5

6

9

11

7

10

B

12

2

1

+

+

+

+

A

B

C

8

3

4

*Fig. 5*

B

B max

B min

A

B

C

Z

*Fig. 6*

*Fig. 7*

*Fig. 8*

Fig. 9

Fig. 10

*Fig. 11*

*Fig. 12*

*Fig. 13*

*Fig. 14*

*Fig. 15*

*Fig. 16*

**Office européen des brevets**

# RAPPORT DE RECHERCHE EUROPEENNE

Numéro de la demande

EP 00 20 2764

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| Y,D | EP 0 879 897 A (COCKERILL RECH & DEV) 25 novembre 1998 (1998-11-25)<br><br>* page 2, ligne 27 - ligne 56; figure 1 *<br>--- | 1-7, 10-16, 18-21, 24,25,32 | C23F4/00 C23G3/02 C21D1/38 C21D9/56 C23C14/02 H01J37/32 H01J37/34 |
| Y | EP 0 146 446 B (FRANCE ETAT ;CENTRE NAT RECH SCIENT (FR)) 8 novembre 1989 (1989-11-08)<br><br>* colonne 3, ligne 8 - ligne 19; revendications 5,7,10 *<br>* colonne 4, ligne 13 - ligne 36 *<br>--- | 1-7, 10-16, 18-20, 24,25,32 | |
| Y | US 5 855 686 A (RUST RAY DEAN) 5 janvier 1999 (1999-01-05)<br><br>* colonne 4, ligne 5 - ligne 40; revendications 1,5,6; figures 2,3,7 *<br>--- | 1,2,4-7, 18-21, 24,25,32 | |
| X | US 5 354 963 A (MUELLER VOLKER ET AL) 11 octobre 1994 (1994-10-11) * revendications 8,11,13; figure 1 *<br>--- | 1,16,18, 19,24 | **DOMAINES TECHNIQUES RECHERCHES (Int.Cl.7)** |
| A | EP 0 270 144 A (BEKAERT SA NV) 8 juin 1988 (1988-06-08) * revendications 1,5,6,11; figure 1 *<br>--- | 1,11,18 | C23F C23G C21D C23C H01J |
| A | EP 0 396 919 A (APPLIED MATERIALS INC) 14 novembre 1990 (1990-11-14) * colonne 6, ligne 28 - colonne 7, ligne 16; revendications 10-13 *<br>--- | 2-9, 19-28 | |
| A | US 3 654 108 A (SMITH HUGH R JR) 4 avril 1972 (1972-04-04) * figures 1,2 *<br>----- | 1,18 | |

Le présent rapport a été établi pour toutes les revendications

| Lieu de la recherche | Date d'achèvement de la recherche | Examinateur |
|---|---|---|
| LA HAYE | 23 janvier 2001 | Bombeke, M |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03 82 (P04C02)

**ANNEXE AU RAPPORT DE RECHERCHE EUROPEENNE
RELATIF A LA DEMANDE DE BREVET EUROPEEN NO.**

EP 00 20 2764

La présente annexe indique les membres de la famille de brevets relatifs aux documents brevets cités dans le rapport de
recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

23-01-2001

| Document brevet cité au rapport de recherche | | Date de publication | Membre(s) de la famille de brevet(s) | | Date de publication |
|---|---|---|---|---|---|
| EP 0879897 | A | 25-11-1998 | BE | 1010913 A | 02-03-1999 |
| | | | JP | 10219344 A | 18-08-1998 |
| | | | US | 6099667 A | 08-08-2000 |
| EP 0146446 | B | 26-06-1985 | FR | 2555362 A | 24-05-1985 |
| | | | DE | 3480450 D | 14-12-1989 |
| | | | EP | 0146446 A | 26-06-1985 |
| | | | FR | 2627903 A | 01-09-1989 |
| US 5855686 | A | 05-01-1999 | US | 5670415 A | 23-09-1997 |
| | | | US | 6035805 A | 14-03-2000 |
| | | | JP | 8176807 A | 09-07-1996 |
| US 5354963 | A | 11-10-1994 | DE | 4211167 A | 07-10-1993 |
| | | | AT | 183437 T | 15-09-1999 |
| | | | AT | 169345 T | 15-08-1998 |
| | | | CA | 2093035 A | 01-10-1993 |
| | | | CA | 2093036 A | 01-10-1993 |
| | | | DE | 59308835 D | 10-09-1998 |
| | | | DE | 59309734 D | 23-09-1999 |
| | | | EP | 0563735 A | 06-10-1993 |
| | | | EP | 0563736 A | 06-10-1993 |
| | | | ES | 2137204 T | 16-12-1999 |
| | | | ES | 2121885 T | 16-12-1998 |
| | | | JP | 6116883 A | 26-04-1994 |
| | | | JP | 6057467 A | 01-03-1994 |
| | | | US | 5366569 A | 22-11-1994 |
| EP 0270144 | A | 08-06-1988 | NL | 8602760 A | 16-05-1988 |
| | | | JP | 63186861 A | 02-08-1988 |
| EP 0396919 | A | 14-11-1990 | JP | 2310383 A | 26-12-1990 |
| | | | KR | 161683 B | 01-02-1999 |
| | | | US | 5225024 A | 06-07-1993 |
| US 3654108 | A | 04-04-1972 | AUCUN | | |

EPO FORM P0460

Pour tout renseignement concernant cette annexe : voir Journal Officiel de l'Office européen des brevets, No.12/82